# EUROPÄISCHE PATENTSCHRIFT

(11) **EP 1 020 105 B1**
(45) Veröffentlichungstag und Bekanntmachung des Hinweises auf die Patenterteilung: **13.03.2002**
(21) Anmeldenummer: 98954206.3
(22) Anmeldetag: 21.09.1998
(51) Int. Cl.: H05K 13/08

(54) **VERFAHREN ZUR BELEUCHTUNGSEINSTELLUNG IN EINER EINRICHTUNG ZUR LAGEERKENNUNG UND/ODER QUALITÄTSKONTROLLE VON BAUELEMENTEN UND/ODER SUBSTRATEN**
METHOD FOR REGULATING THE LIGHTING IN A DEVICE FOR IDENTIFYING THE POSITION OF AND/OR CONTROLLING THE QUALITY OF COMPONENTS AND/OR SUBSTRATES
PROCEDE DE REGLAGE DE L'ECLAIREMENT DANS UN DISPOSITIF DE DETECTION DE POSITION ET/OU DE CONTROLE DE QUALITE DE COMPOSANTS ET/OU DE SUBSTRATS

(30) Priorität: 08.10.1997 DE 19744454
(43) Veröffentlichungstag der Anmeldung: 19.07.2000
(73) Patentinhaber: SIEMENS AKTIENGESELLSCHAFT, 80333 München (DE)
(72) Erfinder: HAAS, Gerhard, D-85764 Oberschleissheim (DE)
(86) Internationale Anmeldenummer: DE9802795
(87) Internationale Veröffentlichungsnummer: WO9920093

(56) Entgegenhaltungen:
- DE-A- 4 222 804
- US-A- 5 469 294

## Beschreibung

Die Erfindung bezieht sich auf ein Verfahren zur Beleuchtungseinstellung in einer Einrichtung zur Lageerkennung und/oder Qualitätskontrolle von Bauelementen und/oder Substraten nach dem Oberbegriff des Patentanspruchs 1.

Bei der automatischen Bestückung von Leiterplatten oder Keramiksubstraten mit Bauelementen, insbesondere SMD-(surface mounted device) - Bauelementen, wird vor dem Bestücken die Lage der Bauelemente relativ zur Aufsetzposition auf der Leiterplatte mittels Einrichtungen zur Lageerkennung bestimmt. Unter dem Begriff Bauelemente werden im folgenden alle bestückfähigen Gegenstände erfaßt, beispielsweise auch Abschirmbleche. Als Lageerkennungseinrichtungen werden im allgemeinen Visionsysteme eingesetzt, die eine Kamera, beispielsweise eine CCD-Kamera, und eine Beleuchtungseinrichtung umfassen. Eine visuelle Inspektion der Bauelemente erfolgt in analog aufgebauten Einrichtungen zur Qualitätskontrolle, um defekte Bauelemente zu erkennen und aus dem Bestückprozeß zu entfernen.

Zur Lageerkennung der Substrate dienen auf den Substraten aufgebrachte Zentriermarkierungen. Für das Markieren defekter Substrate werden auf den Substraten aufgebrachte Ausschußmarkierungen benutzt, damit diese defekten Substrate in der Einrichtung zur Qualitätskontrolle identifiziert und anschließend aus dem Bestückprozeß entfernt werden. Es werden unterschiedlichste Substrate (Epoxi-/Glasfaserverbunde, Kunststoff-Folien, Keramiken, Hartpapier) verwendet. Auch für die Markierungen werden unterschiedliche Materialien wie glänzende oder matte Metalle/Metalloxide oder Kunststoff- oder Lackabdeckungen benutzt. Die optischen Oberflächeneigenschaften dieser unterschiedlichen Materialien für Substrate und Markierungen variieren extrem und damit auch der durch eine Beleuchtung hervorgerufene Kontrast zwischen der Markierung und dem Substrat. Die Beleuchtung ist daher so zu wählen, daß Nutzstrukturen (im allgemeinen die Anschlüsse der Bauelemente oder die Markierungen) sehr kontrastreich gegenüber Störstrukturen (beispielsweise der Körper der Bauelemente oder Substrathintergrund) dargestellt werden.

Für diesen Zweck sind Verfahren bekannt, bei denen mit Hilfe von Beleuchtungseinrichtungen, die in mehrere Beleuchtungseinheiten mit jeweils separat regelbarer Intensitätssteuerung unterteilt sind, die Bauelemente aus unterschiedlichen Winkeln mit unterschiedlichen Intensitäten beleuchtet werden. Die Beleuchtungseinrichtungen haben dabei eine nahezu konstante Spektralverteilung.

Aus WO 96/21343 ist beispielsweise ein Verfahren bekannt, bei dem mit Hilfe einer segmentierten Ringbeleuchtung die Bauelemente nicht aus allen Winkeln gleichmäßig beleuchtet werden, sondern aus bestimmten Winkeln kein Licht auf die Struktur fällt. Damit werden Abbildungen von unter diesen bestimmten Winkeln besonders auffällig hervortretenden Störstrukturen unterdrückt.

Markierungen und Substrate und/oder Bauelemente werden dabei jeweils aus Materialien mit zueinander unterschiedlichen optischen Eigenschaften wie Absorption, metallische oder diffuse Reflexion hergestellt, um bei der Beleuchtung mit einer Beleuchtungseinrichtung mit nahezu konstanter Spektralverteilung durch ihr jeweils unterschiedliches Rückstreuverhalten in einer Bildauswerteeinheit voneinander unterschieden zu werden. Die optischen Eigenschaften variieren mit der Wellenlänge des beleuchtenden Lichts, so daß in nachteiliger Weise bei der Beleuchtung mit nahezu konstanter Spektralverteilung bestimmte Materialkombinationen für Markierungen, Substrate und/oder Bauelemente nicht voneinander unterschieden werden können. Ein Austausch der Beleuchtungseinrichtungen in Abhängigkeit von den verwendeten Materialien ist sehr aufwendig und bei einer anzustrebenden hohen Bestückleistung aufgrund des Zeitverlustes nicht durchführbar.

Aus JP 5-332939 ist ein Verfahren für die Qualitätskontrolle von Bauelementen mit einer Anzahl von Beleuchtungseinheiten bekannt, die jeweils eigene Intensitätssteuereinrichtungen aufweisen. Dabei wird das von den Beleuchtungseinheiten emittierte Licht durch Veränderung der Intensität verändert, bis eine optimale Beleuchtung (maximaler Kontrast) erreicht wird, bei der das Bauelement sicher erkannt wird.

Aus JP 8-219716 A ist ein Verfahren zum Beleuchten von Objekten mit unterschiedlichen Farben bekannt, bei dem über eine Beleuchtungssteuerung die Farbe des von einer Beleuchtungseinheit emittierten Lichts verändert wird.

Die Verwendung von unterschiedlichen Farben für die Kontrastoptimierung wird dadurch erschwert, daß bei den bekannten Verfahren der Bediener selbst den optimalen Kontrast für jedes untersuchte Bauelement einstellen muß.

Es ist daher Aufgabe der Erfindung, ein Verfahren zur Beleuchtungseinstellung anzugeben, die bei unterschiedlichen verwendeten Materialien für Substrate, Markierungen und/oder Bauelemente eine zuverlässige Erkennung gewährleistet und dabei für Bauelemente gleichen Typs eine schnelle Erkennung bewirkt.

Die Aufgabe wird erfindungsgemäß mit einem Verfahren der eingangs genannten Art mit den kennzeichnenden Merkmalen des Patentanspruches 1 gelöst.

Gegenüber den bekannten Verfahren weist das erfindungsgemäße Verfahren den Vorteil auf, daß die Spektralverteilung der Beleuchtung durch Variation der Parameter der Intensitätssteuereinrichtung verändert wird. Da Reflexions- bzw. Rückstreuverhalten der Materialien für Bauelemente, Markierungen und Substrate wellenlängenabhängig sind, wird eine farboptimierte Beleuchtung erzielt, die einen verbesserten Kontrast zwischen Stör- und Nutzstrukturen für aus unterschiedlichen Materialien hergestellte Bauelemente, Substrate und/oder Markierungen ermöglicht. Dabei wird bei einer Gruppe von gleichartigen Bauelementen und/oder Markierungen zunächst die optimierte Beleuchtungseinstellung für ein erstes Bauelement und/oder eine erste Markierung ermittelt. Die sich daraus ergebenden Parameter für die Intensitätseinstellung werden gespeichert und können für die Beleuchtung der weiteren Bauelemente und/oder Markierungen verwendet werden. Damit ist eine gleich gute Erkennbarkeit gleichartiger Bauelemente und/oder Markierungen sichergestellt.

In einer besonders einfach zu realisierenden Ausgestaltung des Verfahrens nach Anspruch 2 emittieren die Beleuchtungseinheiten jeweils Licht in einem schmalbandigen Spektralbereich, wobei unterschiedliche Beleuchtungseinheiten in unterschiedlichen Spektralbereichen Licht emittieren. Durch die jeweils den Beleuchtungseinheiten zugeordneten Intensitätssteuereinrichtungen werden die Intensitäten der einzelnen Beleuchtungseinheiten variiert, so daß Beleuchtungen mit einer unterschiedlichen spektralen Intensitätsfarbverteilung eingestellt werden.

In einer weiteren Ausgestaltung nach Anspruch 3 werden Beleuchtungseinheiten benutzt, deren Emissionswellenlänge veränderbar ist. In diesem Fall wird die Emissionswellenlänge ebenfalls mit der Intensitätssteuereinrichtung variiert. Dadurch werden weniger Beleuchtungseinheiten eingesetzt und eine kompaktere Bauweise erzielt.

In der vorteilhaften Ausgestaltung des Verfahrens nach Patentanspruch 4 wird die optimierte Beleuchtung automatisch ermittelt, was zu einer besseren Reproduzierbarkeit bei der Beleuchtungseinstellung führt.

In dem Verfahren gemäß Anspruch 5 wird in vorteilhafter Weise die Intensität einer Gruppe von Beleuchtungseinheiten, die jeweils Licht in einem gemeinsamen Spektralbereich emittieren, gemeinsam variiert. Damit wird die Anzahl der einzeln anzusteuernden Intensitätssteuereinrichtungen reduziert und damit auch die Zeit, um eine optimierte Beleuchtung zu ermitteln.

Anhand eines Ausführungsbeispiel und den Figuren der Zeichnung wird die Erfindung näher erläutert. Dabei zeigen
Figur 1 eine schematische Darstellung eines Bestückautomaten zum Bestücken von Bauelementen auf Substraten,
Figur 2 schematisch eine Beleuchtungsvorrichtung für die Beleuchtung von Substraten mit Markierungen und
Figur 3 schematisch eine Beleuchtungsvorrichtung zum Beleuchten von Bauelementen.

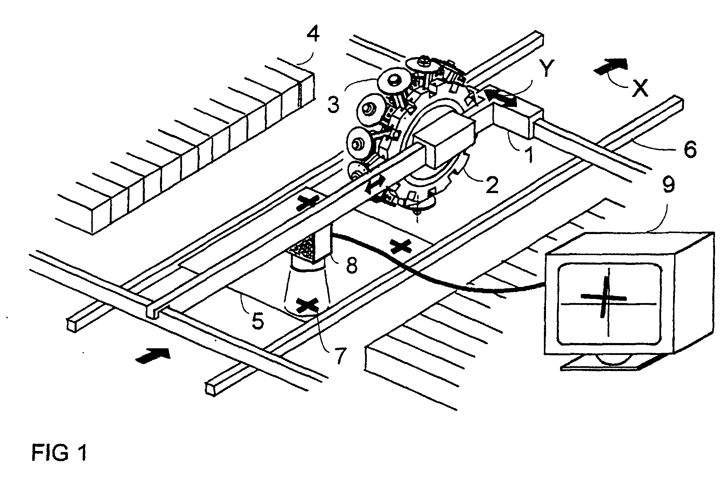

In Figur 1 ist dargestellt, wie sich ein an einem Portal 1 befindlicher Bestückkopf 2 in einem Bestückautomaten in X- und Y-Richtung mit Hilfe von nicht dargestellten Motoren bewegen läßt. An dem Bestückkopf sind Saugpipetten 3, in diesem Beispiel 12 Stück, befestigt, mit denen nicht dargestellte Bauelemente aus Zuführeinrichtungen 4 aufgenommen und auf Substraten 5 auf eine vorher bestimmte Position abgesetzt werden. Mit dem Begriff Substrat 5 werden sowohl Leiterplatten als auch Keramiksubstrate umfaßt. Die Substrate 5 werden dabei durch eine Substratbewegungsvorrichtung 6 in X-Richtung transportiert. Zur Korrektur der Lage der Bauelemente zum Substrat 5 sind auf dem Substrat 5 Markierungen 7 angebracht, die von einer Beleuchtungseinrichtung 8 abgebildet und in einer Bildauswerteeinheit 9 abgespeichert werden. In diesem Beispiel ist ein Monitor zur visuellen Betrachtung als Bildauswerteeinheit 9 angeordnet. Neben Zentriermarkierungen 7 zur Lageerkennung des Substrats 5 werden auf diese Weise auch Ausschußmarkierungen 7 detektiert, die auf für den weiteren Bestückprozeß ungeeigneten Substraten 5 aufgebracht wurden. Diese ungeeigneten Substrate 5 werden auf diese Weise erkannt und anschließend aus dem Bestückprozeß entfernt.

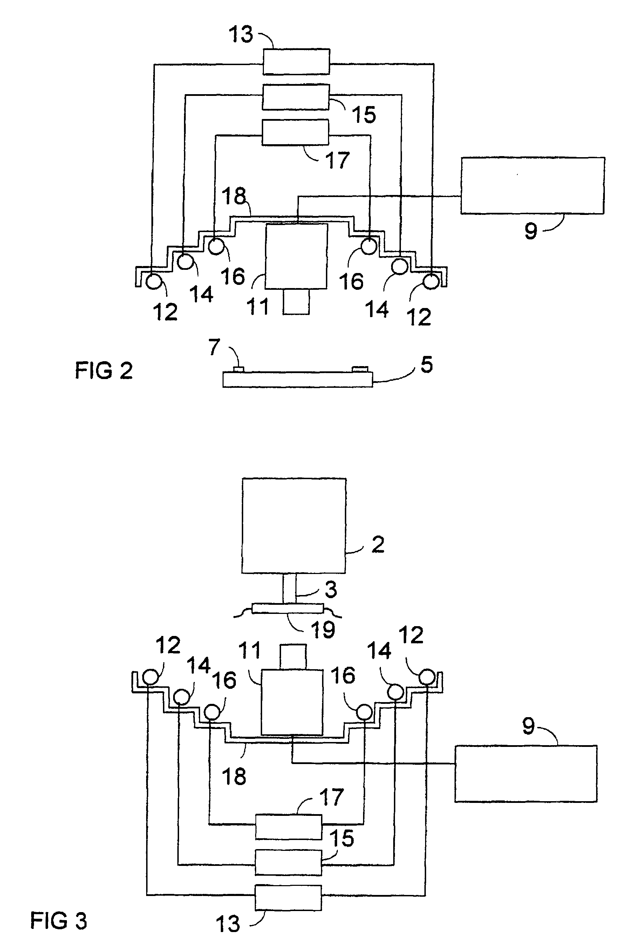

In dem erfindungsgemäßen Verfahren wird als Beleuchtungseinrichtung 8 beispielsweise eine Vorrichtung, wie sie in Figur 2 dargestellt ist, verwendet. Dabei nimmt eine Kamera 11, beispielsweise eine CCD-Kamera, das Bild des Substrates 5 mit den Markierungen 7 auf und speichert die Abbildung in einer nachgeschalteten Bildauswerteeinheit 9. Beleuchtet wird das Substrat 5 mit den Markierungen 7 durch Beleuchtungseinheiten 12,14,16 wobei erste Beleuchtungseinheiten 12 Licht in einem schmalen Spektralbereich um eine erste Wellenlänge emittieren, deren Intensität durch eine gemeinsame Intensitätssteuereinrichtung 13 variiert wird. Zusätzlich sind zweite Beleuchtungseinheiten 14 vorgesehen, die Licht in einem zweiten schmalbandigen Spektralbereich um eine zweite Wellenlänge emittieren, und von einer gemeinsamen Intensitätssteuereinrichtung 15 in ihrer Intensität variiert werden, sowie dritte Beleuchtungseinheiten 16, die in einem dritten schmalbandigen Spektralbereich um eine dritte Wellenlänge emittieren und von einer dritten Intensitätssteuereinrichtung 17 in ihrer Intensität variiert werden. Die Beleuchtungseinheiten 12, 14, 16 sind dabei mit der Kamera 11 durch eine Befestigungsvorrichtung 18 fest verbunden, damit sie sich mit der Kamera 11 gleichzeitig über das Substrat 5 bewegen lassen. Die Beleuchtungseinheiten 12, 14, 16 sind dabei beispielsweise als ringförmige Lichtquelle ausgebildet. Für eine optimierte Beleuchtung werden die einzelnen Beleuchtungseinheiten 12, 14, 16 in ihrer Intensität variiert, in dem die Parameter an den zugeordneten Intensitätssteuereinrichtungen 13, 15, 17 solange verändert werden, bis eine optimierte Beleuchtung mit optimiertem Kontrast durch die Kamera 11 aufgenommen und in der Bildauswerteeinheit 9 abgespeichert ist. Bei der Benutzung von wellenlängenveränderlichen Beleuchtungseinrichtungen 12,14,16, wie beispielsweise wellenlängenveränderlichen Leuchtdioden, wird der emittierte Spektralbereich durch die Intensitätssteuereinrichtungen 13,15,17 verändert.

Werden während des Bestückprozesses mehrere gleichartige Substrate 5 mit gleichartigen Markierungen 7 beleuchtet und deren Abbilder aufgenommen, so wird in einer Trainingsphase zunächst nur an einer Markierung 7 die optimierte Beleuchtungseinstellung ermittelt, die entsprechenden Parameter abgespeichert und die weiteren gleichartigen Markierungen 7 mit der diesen Parametern zugeordneten optimalen Beleuchtung beaufschlagt. Dieser Vorgang läßt sich beispielsweise dadurch automatisieren, daß zu Beginn des Bestückprozesses die Stör- und die Nutzstrukturen der Markierungen 7 und der Substrate 5 als geometrische Strukturen abgespeichert werden und während der Trainingsphase die Intensitäten der unterschiedlichen Beleuchtungseinheiten 12,14,16 variiert, die entsprechenden Abbildungen abgespeichert, die daraus erzielten Kontraste ermittelt und daraus der optimierte Kontrast und damit die optimierten Intensitätseinstellungen ermittelt werden. In Figur 2 ist auch bereits dargestellt, daß die unterschiedlichen Beleuchtungseinheiten 12,14,16 das Substrat 5 und damit die Markierungen 7 aus unterschiedlichen Richtungen beleuchten. Besonders geeignet sind Leuchtdioden als Beleuchtungseinheiten 12, 14, 16 da sie preiswert sind und sich ihre Intensität einfach regulieren läßt. Die Leuchtdioden sind in unterschiedlichen Spektralfarben emittierend erhältlich. Zudem lassen sich Leuchtdioden leicht in einer Matrix anordnen, wodurch eine großflächige Beleuchtungseinrichtung 8 erzielt wird.

In Figur 3 ist dargestellt, daß das erfindungsgemäße Verfahren auch für die Beleuchtung von Bauelementen 19 an der Saugpipette 3 eines Bestückkopfes 1 geeignet ist, um die Lage des Bauelementes zu bestimmen. Dabei bilden im allgemeinen die Anschlüsse des Bauelementes 19 die Nutz- und der Körper des Bauelementes 19 die Störstrukturen. Analog zum beschriebenen Verfahren bei Markierungen 7 und Substraten 5 wird in einer Trainingsphase zunächst die optimale Beleuchtung für ein erstes Bauelement 19 ermittelt und anschließend für weitere gleichartige Bauelemente 19 verwendet.

Das erfindungsgemäße Verfahren besitzt daher den Vorteil für aus unterschiedlichsten Materialien bestehende Bauelemente 19, Substrate 5 und/oder Markierungen 7 eine jeweils optimierte Beleuchtung zu gewährleisten.

## Patentansprüche

1. Verfahren zur Beleuchtungseinstellung in einer Einrichtung zur Lageerkennung und/oder Qualitätskontrolle von Bauelementen (19) und/oder Substraten (5), wobei die Einrichtung eine Beleuchtungseinrichtung (8) aus Beleuchtungseinheiten (12, 14, 16) mit jeweils zugeordneten Beleuchtungssteuereinrichtungen (13,15,17) sowie eine zugeordnete Kamera (11) mit nachgeschalteter Bildauswerteeinheit (9) umfaßt, welche zumindest bereichsweise eine Abbildung der Bauelemente (19) und/oder von auf den Substraten (5) angeordneten Markierungen (7) aufnimmt,
wobei das von den Beleuchtungseinheiten (12,14,16) emittierte Licht in seiner Spektralverteilung durch eine Veränderung von Parametern der zugeordneten Beleuchtungssteuereinrichtungen (13,15,17) verändert wird, bis eine optimierte Beleuchtung erreicht wird, bei der das Bauelement (19) und/oder die Markierung (7) nach der Aufnahme mit der Kamera (11) in der Bildauswerteeinheit (9) sicher erkannt wird, **dadurch gekennzeichnet,**
**daß** für die Bestückung einer Gruppe von gleichartigen Bauelementen (19) und/oder die Erkennung einer Gruppe von gleichartigen Markierungen (7) zunächst ein erstes Bauelement (19) und/oder eine erste Markierung (7) der jeweiligen Gruppe beleuchtet wird,
**daß** für dieses erste Bauelement (19) und/oder diese erste Markierung (7) die Parameter der Beleuchtungssteuereinrichtungen (13,15,17) für die optimale Beleuchtung bestimmt und abgespeichert werden
und **daß** die abgespeicherten Parameter für die Beleuchtung von weiteren Bauelementen (19) und/oder weiteren Markierungen (7) der jeweiligen Gruppe verwendet werden.

2. Verfahren zur Beleuchtungseinstellung nach Anspruch 1,
**dadurch gekennzeichnet,**
**daß** die Beleuchtungseinheiten (12,14,16) jeweils Licht in einem schmalbandigen Spektralbereich um eine den jeweiligen Beleuchtungseinheiten (12,14,16) zugeordnete Wellenlänge emittieren, wobei sich die Wellenlängen von mindestens zwei Beleuchtungseinheiten (12,14,16) voneinander unterscheiden, und daß die Intensität der jeweiligen Beleuchtungseinheiten (12,14,16) separat durch eine Veränderung von Parametern der jeweils zugeordneten Beleuchtungssteuereinrichtungen (13,15,17) variiert wird.

3. Verfahren zur Beleuchtungseinstellung nach einem der Ansprüche 1 oder 2,
**dadurch gekennzeichnet, daß** die Wellenlänge des von den Beleuchtungseinheiten (12,14,16) emittierten Lichts durch eine Variation der Parameter der Beleuchtungssteuereinrichtung (13, 15, 17) verändert wird.

4. Verfahren zur Beleuchtungseinstellung nach einem der Ansprüche 1, 2 oder 3,
**dadurch gekennzeichnet,**
**daß** die optimale Beleuchtung dadurch automatisch ermittelt wird,
**daß** geometrische Strukturen der Bauelemente (19) und/oder der Markierungen (7) in Stör- und Nutzstrukturen aufgeteilt werden,
**daß** die Stör- und Nutzstrukturen abgespeichert werden,
**daß** das erste Bauelement (19) und/oder die erste Markierung (7) durch Verändern der Parameter mit unterschiedlichen Intensitäten der einzelnen Beleuchtungseinheiten (12,14,16) beleuchtet, abgebildet und resultierende Kontraste zwischen den Stör- und den Nutzstrukturen in der Bildauswerteeinheit (9) abgespeichert werden und
**daß** aus den resultierenden Kontrasten der optimale Kontrast zwischen den Stör- und Nutzstrukturen ermittelt wird und aus dem optimalen Kontrast die dazugehörigen Parameter ermittelt, abgespeichert und für die Beleuchtung der weiteren Bauelemente (19) und/oder der weiteren Markierungen (7) der jeweiligen Gruppe verwendet werden.

5. Verfahren zur Beleuchtungseinstellung nach einem der Ansprüche 1 bis 4,
**dadurch gekennzeichnet,**
**daß** die Intensität einer Gruppe von Beleuchtungseinheiten (12,14,16), die jeweils Licht in einem Spektralbereich um eine für diese Gruppe gemeinsame Wellenlänge emittieren, gemeinsam variiert wird.

## Claims

1. Method for setting the illumination in a device for identifying the position and/or controlling the quality of components (19) and/or substrates (5), the device comprising an illumination device (8) made of illumination units (12, 14, 16) with respectively assigned illumination control devices (13, 15, 17), and an assigned camera (11) with an image evaluation unit (9) connected downstream, which, at least in regions, records an imaging of the components (19) and/or of markings (7) arranged on the substrates (5), the spectral distribution of the light emitted by the illumination units (12, 14, 16) being varied by variation of parameters of the assigned illumination control device (13, 15, 17) until an optimized illumination is achieved, in the case of which the component (19) and/or the marking (7) is reliably identified in the image evaluation unit (9) after recording by the camera (11),
**characterized**
**in that**, for the mounting of a group of identical components (19) and/or the identification of a group of identical markings (7), first of all a first component (19) and/or a first marking (7) of the respective group is illuminated,
**in that**, for this first component (19) and/or this first marking (7), the parameters of the illumination control devices (13, 15, 17) for the optimum illumination are determined and stored,
and **in that** the stored parameters are used for illuminating further components (19) and/or further markings (7) of the respective group.

2. Method for setting the illumination according to Claim 1,
**characterized**
**in that** the illumination units (12, 14, 16) each emit light in a narrowband spectral range around a wavelength assigned to the respective illumination units (12, 14, 16), the wavelengths of at least two illumination units (12, 14, 16) differing from one another,
and **in that** the intensity of the respective illumination units (12, 14,16) is varied separately by variation of parameters of the respectively assigned illumination control devices (13, 15, 17).

3. Method for setting the illumination according to either of Claims 1 and 2,
**characterized**
**in that** the wavelength of the light emitted by the illumination units (12, 14, 16) is varied by variation of the parameters of the illumination control device (13, 15, 17).

4. Method for setting the illumination according to one of Claims 1, 2 or 3,
**characterized**
**in that** the optimum illumination is determined automatically by virtue of the fact
that geometrical structures of the components (19) and/or of the markings (7) are divided into defective and useful structures,
that the defective and useful structures are stored,
that the first component (19) and/or the first marking (7) is illuminated with different intensities of the individual illumination units (12, 14, 16) by variation of the parameters, and imaged, and resulting contrasts between the defective and useful structures are stored in the image evaluation unit (9), and
that the optimum contrast between the defect and useful structures is determined from the resulting contrasts, and the associated parameters are determined from the optimum contrast, stored and used for illuminating the further components (19) and/or the further markings (7) of the respective group.

5. Method for setting the illumination according to one of Claims 1 to 4, **characterized in that** the intensity of a group of illumination units (12, 14, 16) which each emit light in a spectral range around a wavelength that is common to this group is varied jointly.

## Revendications

1. Procédé de réglage de l'éclairement dans un dispositif de reconnaissance de position et/ou de contrôle de qualité de composants (19) et/ou de substrats (5), le dispositif comprenant un dispositif (6) d'éclairage constitué d'unités (12, 14, 16) d'éclairage ayant respectivement des dispositifs (13, 15, 17) de commande d'éclairage associés ainsi qu'une caméra (11) associée à unité (9) d'exploitation de l'image en aval, qui enregistre au moins par endroits une reproduction des composants (19) et/ou de repères (7) apposés sur les substrats (5),
la répartition spectrale de la lumière émise par les unités (12, 14, 16) d'éclairage étant modifiée par une modification de paramètres des dispositifs (13, 15, 17) de commande d'éclairage associés jusqu'à obtenir un éclairage optimisé pour lequel le composant (19) et/ou le repère (7) peut, après l'enregistrement par la caméra (11), être reconnu de manière sûre dans l'unité (9) d'exploitation de l'image, **caractérisé**
**en ce que** pour l'implantation d'un groupe de composants (19) de même type et/ou pour la reconnaissance d'un groupe de repères (7) de même type on éclaire d'abord un premier composant (19) et/ou un premier repère (7) du groupe respectif,
**en ce que** l'on détermine pour ce premier élément (19) et/ou ce premier repère (7) les paramètres des dispositifs (13, 15, 17) d'éclairage pour l'éclairage optimum et on les mémorise
et **en ce que** l'on utilise les paramètres mémorisés pour l'éclairage d'autres composants (19) et/ou d'autres repères (7) du groupe respectif.

2. Procédé de réglage de l'éclairement suivant la revendication 1, **caractérisé en ce que** les unités (12, 14, 16) d'éclairage émettent respectivement de la lumière dans un domaine spectral à bande étroite autour d'une longueur d'onde associée aux unités (12, 14, 16) respectives d'éclairage, les longueurs d'onde d'au moins deux unités (12, 14, 16) d'éclairage étant différentes l'une de l'autre et **en ce que** l'intensité des unités (12, 14, 16) d'éclairage respectives est modifiée séparément par une modification de paramètres des dispositifs (13, 15, 17) de commande d'éclairage respectivement associés.

3. Procédé de réglage de l'éclairement suivant la revendication 1 ou 2, **caractérisé en ce que** la longueur d'onde de la lumière émise par les unités (12, 14, 16) d'éclairage est modifiée par une variation des paramètres du dispositif (13, 15, 17) d'éclairage.

4. Procédé de réglage de l'éclairement suivant l'une des revendications 1, 2 ou 3, **caractérisé en ce que** l'éclairement optimum est déterminé automatiquement par le fait que
des structures géométriques des composants (19) et/ou des repères (7) sont subdivisées en structures gênantes et en structures utiles,
par le fait que les structures gênantes et les structures utiles sont mémorisées,
par le fait que le premier composant (19) et/ou le premier repère (7) sont éclairés en modifiant les paramètres avec des intensités différentes des unités (12, 14, 16) d'éclairage individuelles sont reproduits et que les contrastes résultant entre les structures gênantes et les structures utiles sont mémorisés dans l'unité (9) d'exploitation de l'image et
par le fait que, à partir des contrastes résultants on détermine le contraste optimum entre les structures gênantes et les structures utiles et, à partir du contraste optimum, on détermine les paramètres correspondants, on les mémorise et on les utilise pour l'éclairement des autres composants (19) et/ou des autres repères (7) du groupe respectif.

5. Procédé de réglage de l'éclairement suivant l'une des revendications 1 à 4, **caractérisé en ce que** l'on fait varier en commun l'intensité d'un groupe d'unités (12, 14, 16) d'éclairage qui émettent respectivement de la lumière dans un domaine spectral autour d'une longueur d'onde commune pour ce groupe.
